(19) Europäisches Patentamt / European Patent Office / Office européen des brevets

(11) **EP 2 418 531 A1**

(12) **EUROPEAN PATENT APPLICATION**

(43) Date of publication:
**15.02.2012 Bulletin 2012/07**

(21) Application number: **11176977.4**

(22) Date of filing: **09.08.2011**

(51) Int Cl.:
*G02B 17/08* (2006.01)　　*G02B 3/00* (2006.01)
*F21V 13/04* (2006.01)　　*H01L 33/58* (2010.01)
*F21K 99/00* (2010.01)　　*B29D 11/00* (2006.01)
*F21V 5/04* (2006.01)　　*F21V 7/00* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **09.08.2010 KR 20100076301**

(71) Applicant: **Samsung LED Co., Ltd.**
**Yeongtong-gu, Suwon**
**Gyunggi-do 443-743 (KR)**

(72) Inventor: **Ariyoshi, Tetsuo**
**Osaka-shi, Osaka (JP)**

(74) Representative: **Zimmermann & Partner**
**Josephspitalstr. 15**
**80331 München (DE)**

(54) **Optical lens and lighting apparatus**

(57) There are provided an optical lens and a lighting apparatus using the same. The optical lens (10) includes an incidence part (13) provided as a light incident area and including a micro lens array (14) formed on at least a partial region of a surface thereof; a reflection part (11) spaced apart from the incidence part (13) by a predetermined distance (H) and reflecting at least a certain amount of light having passed through the incidence part (13); and a side surface part (12) connecting the incidence part (13) and the reflection part (11) and transmitting the certain amount of light reflected by the reflection part (11). In the case of using the optical lens (10), when light incident from the light source (20) is emitted to the outside, an angle at which the light is emitted therefrom is enlarged, whereby an orientation angle of the light source is improved.

FIG. 2

## Description

## CROSS-REFERENCE TO RELATED APPLICATIONS

This application claims the priority of Korean Patent Application No. 10-2010-0076301 filed on August 9, 2010, in the Korean Intellectual Property Office, the disclosure of which is incorporated herein by reference.

## BACKGROUND OF THE INVENTION

### Field of the Invention

The present invention relates to an optical lens and a lighting apparatus using the same, and more particularly, to a lighting apparatus having a light distribution curve suitable for use in lighting having a wide range of uses by employing an optical lens having an improved orientation angle.

### Description of the Related Art

In general, a light emitting diode (LED), a kind of semiconductor light source, is a semiconductor device capable of generating light of various colors due to the recombination of electrons and electron holes at the junction between a p-type semiconductor and an n-type semiconductor, when current is applied thereto.

Demand for this light emitting diode has been continuously increasing, since the light emitting diode has various advantages, such as long lifespan, low power consumption, superior initial driving characteristics, high vibration resistance, and the like, as compared to a filament-based light source. In particular, a group III-nitride semiconductor capable of emitting blue light having a short wavelength has recently come to prominence.

Recently, there has been an attempt at replacing a lighting apparatus in the related art, such as an incandescent lamp or a fluorescent lamp by using light emitting diodes. However, in the case of light emitting diodes, light is emitted in a particular direction rather than being uniformly emitted in all directions, and, in general, an orientation angle is in the range of approximately 120°. These light contribution characteristics of light emitting diodes show sufficient differences as compared to an incandescent lamp or a fluorescent lamp emitting light in all directions, whereby the light emitting diode is limited to be used as a lighting apparatus having a wide range of uses. Accordingly, in the case of a lighting apparatus using light emitting diodes, a design solution capable of extending the application range of a lighting apparatus using light emitting diodes by using a lens controlling direction of emitted light has been required.

## SUMMARY OF THE INVENTION

An aspect of the present invention provides an optical lens having a shape capable of improving an orientation angle of a light source, and further provides a lighting apparatus having a light distribution curve suitable for use in lighting having a wide range of uses by employing this optical lens.

According to an aspect of the present invention, there is provided an optical lens, including: an incidence part provided as a light incident area and including a micro lens array formed on at least a partial region of a surface thereof;

a reflection part spaced apart from the incidence part by a predetermined distance and reflecting at least a certain amount of light having passed through the incidence part; and a side surface part connecting the incidence part and the reflection part and transmitting the certain amount of light reflected by the reflection part.

The micro lens array may refract at least a certain amount of light incident on the incidence part at an angle at which the light is totally reflected by the reflection part.

The incidence part and the reflection part may be planes parallel with each other.

The reflection part may have a width greater than that of the incidence part.

The incidence part and the reflection part may have round shapes.

The side surface part may have a curved surface shape projecting outwardly.

The micro lens array may be formed of micro lenses, each having a hemispherical shape projecting from a lower surface of the incidence part.

The micro lens array may include at least one micro lens having a hemispherical, conic, triangular pyramidal, quadrangular pyramidal or randomly scattered shape.

The optical lens is made of at least one of polycarbonate and acryl.

According to another aspect of the present invention, there is provided a lighting appratus, including: a light source; and an optical lens including an incidence part provided as a light incident area and including a micro lens array formed on at least a partial region of a surface thereof; a reflection part spaced apart from the incidence part by a predetermined distance and reflecting at least a certain amount of light having passed through the incidence part; and a side surface part connecting the incidence part and the reflection part and transmitting the certain amount of light reflected by the reflection part.

The micro lens array may refract at least a certain amount of light incident on the incidence part at an angle at which the light is totally reflected by the reflection part.

The incidence part and the reflection part may be planes parallel with each other.

The reflection part may have a width greater than that of the incidence part.

The incidence part and the reflection part may have round shapes.

A ratio of a width of the incidence part to a width of a light source may be within a range between 1.8 and 3.2.

A ratio of a width of the reflection part to the width of the light source may be within a range between 3 and 4.2.

The side surface part may have a curved surface shape projecting outwardly.

A ratio of a distance between the reflection part and the incidence part to the width of the light source may be within a range between 0.46 and 0.9.

The micro les array may have a plurality of micro lenses, each having a hemispherical shape projecting from a lower surface of the incidence part.

In the micro les array, an interval between the micro lenses may be uniform.

A ratio of the interval between the micro lenses to the width of the light source may be within a range of 0.08 or more.

A ratio of a radius of the micro lenses to the interval between the micro lenses may be within a range between 0.48 and 0.62.

The optical lens may be made of at least one of polycarbonate and acryl.

A formation area of the micro lens array may be greater than an area corresponding to the light source.

The lighting appratus may further include a heat dissipating structure disposed on a lower surface of the light source.

The lighting appratus may further include a fixing part between the optical lens and the heat dissipating structure.

**BRIEF DESCRIPTION OF THE DRAWINGS**

The above and other aspects, features and other advantages of the present invention will be more clearly understood from the following detailed description taken in conjunction with the accompanying drawings, in which:

FIG. 1 is a schematic perspective view of an optical lens according to an exemplary embodiment of the present invention;
FIG. 2 shows a cross sectional view of a lighting apparatus having a light source disposed below the optical lens of FIG. 1, taken along line A-B, together with light paths therefrom;
FIG. 3 shows a simulated light distribution curve of the lighting apparatus of FIG. 2;
FIG. 4 shows a cross sectional view of a lighting apparatus having a light source disposed below the optical lens of FIG. 1 from which a micro lens array is removed, taken along line A-B, together with light paths therefrom;
FIG. 5 shows a simulated light distribution curve of the lighting apparatus of FIG. 4;
FIG. 6 is a schematic cross sectional view of an optical lens according to an exemplary embodiment of the present invention, which illustrates reference numerals for explaining length relationships between individual parts configuring the optical lens;
FIG. 7 is a graph illustrating a simulated ratio of a radius of an incidence part to a width of a light source in an optical lens according to an exemplary embodiment of the present invention;
FIG. 8 is a graph illustrating a simulated ratio of a radius of a reflection part to the width of the light source in the optical lens according to the exemplary embodiment of the present invention;
FIG. 9 is a graph illustrating a simulated ratio of a distance between the reflection part and the incidence part to the width of the light source in the optical lens according to the exemplary embodiment of the present invention;
FIG. 10 is a graph illustrating a simulated ratio of a distance between a plurality of micro lenses to the width of the light source in the optical lens according to the exemplary embodiment of the present invention;
FIG. 11 is a graph illustrating a simulated ratio of a radius of the plurality of micro lenses to the distance between the plurality of micro lenses in the optical lens according to the exemplary embodiment of the present invention;
FIG. 12 is a schematic cross sectional view of a lighting apparatus using the optical lens according to the exemplary embodiment of the present invention;
FIG. 13 is a simulated light distribution curve of the lighting apparatus according to the exemplary embodiment of the present invention.

**DETAILED DESCRIPTION OF THE PREFERRED EMBODIMENT**

Exemplary embodiments of the present invention will now be described in detail with reference to the accompanying drawings. The invention may, however, be embodied in many different forms and should not be construed as being limited to the embodiments set forth herein. Rather, these embodiments are provided so that this disclosure will be thorough and complete, and will fully convey the scope of the invention to those skilled in the art. In the drawings, the shapes and sizes of components are exaggerated for clarity. While those skilled in the art could readily devise many other varied embodiments that incorporate the teachings of the present invention through the addition, modification or deletion of elements, such embodiments may fall within the scope of the present invention.

The same or equivalent elements are referred to by the same reference numerals throughout the specification.

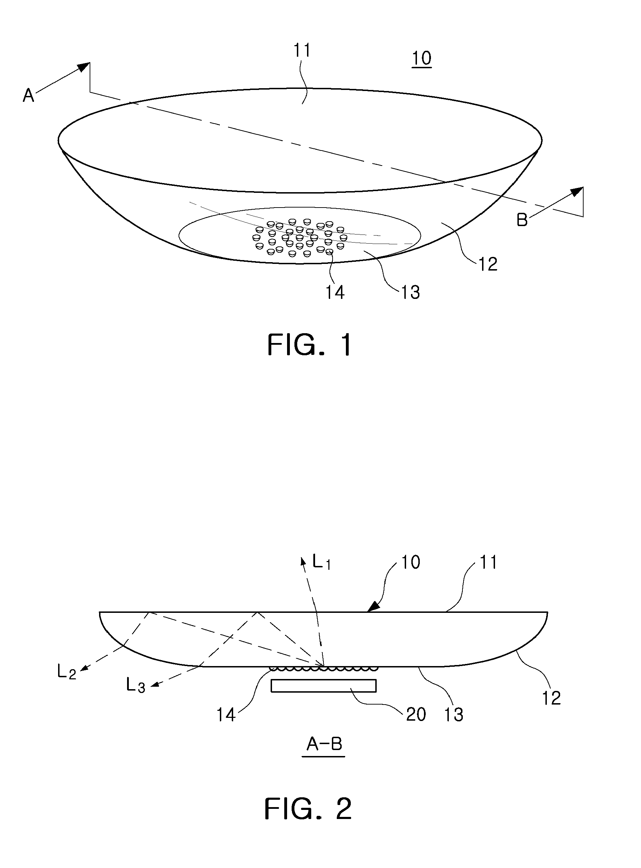

FIG. 1 is a schematic perspective view of an optical lens according to an exemplary embodiment of the present invention.

FIG. 2 is a cross sectional view of a lighting apparatus having a light source disposed below the optical lens of FIG. 1, taken along line A-B, and also shows light paths of light having passed through the optical lens to go on.

Referring to FIGS. 1 and 2, an optical lens 10 according to the exemplary embodiment of the present invention may be provided to have a basic structure formed by an incidence part 13, a reflection part 11 spaced apart from the incidence part 13 by a predetermined distance, and a side surface part 12 connecting the incidence part 13 and the reflection part 11. In this case, the optical lens 10 may be provided to have a shape similar to that of a transparent curved plate. Namely, the incidence part 13 and the reflection part 11 may be provided to have flat circular shapes, the centers of which are aligned. At the same time, the incidence part 13 and the reflection part 11 may be parallel, such that they are continuously or uniformly spaced apart from each other by the same distance. The incidence part 13 and the reflection part 11 spaced apart from each other may be connected through the side surface part 12. As shown in this exemplary embodiment of the present invention, when a width (or a diameter) of the incidence part 13 is formed to be smaller than that of the reflection part 11, the side surface part 12 may have a width narrowing towards the incidence part 13 from the reflection part 11, while having a curved surface shape formed along the incidence part 13 and the reflection part 11 and projecting outwardly of the optical lens 10.

With reference to FIG. 2, a case in which, when a light source 20 is disposed below the optical lens 10 formed as above, that is, centrally disposed below the incidence part 13, light emitted from the light source 20 passes through the optical lens 10 to finally be emitted to the outside, will be explained in detail.

Referring to FIG. 2, a light emitting diode may be used as the light source 20 in the exemplary embodiment of the present invention. As described above, since the light emitting diode may generally have light distribution characteristics having an orientation angle remaining within approximately 120°, light emitted from the light source 20 may not be widely dispersed, whereby the majority of light therefrom may be emitted upwardly. In this case, the emitted light may reach the incidence part 13 of the optical lens 10 disposed to be parallel with the light source 20 in such a manner as to be centrally adjacent to the upper portion of the light source 2. A certain amount of the emitted light may be incident to a micro lens array 14, a certain amount of the emitted light may reach the planar incidence part 13 on which the micro lens array 14 is not formed, and a certain amount of the emitted light may be dispersed or distributed in air, without being guided in a direction of the optical lens 10, may be reflected, or totally reflected from the reflection part 11 of the optical lens 10, thereby being dispersed or distributed. In this case, the greatest quantity of emitted light may be incident to the optical lens 10. This is an important factor in order to disperse or distribute light having a narrow range of orientation angle, which is the characteristic of light emitting diodes, through the optical lens 10. Thus, in the exemplary embodiment of the present invention, the micro lens array 14 may be formed on the incidence part 13 in such a manner as to be disposed more widely than a width of the optical lens 10. By doing so, the quantity of light reflected or totally reflected from the incidence part 13 without being incident on the optical lens 10, to be dispersed may be minimized, thereby eventually contributing to the improvement of the light distribution characteristics.

As described above, the direction of light incident to the micro lens array 14 may be changed through refraction. In this case, an angle at which light is emitted from the micro lens array 14 may be greater than an angle at which the light is incident thereto, which will be explained in detail later with reference to the operation of the reflection part 11. In this manner, since the micro lens array 14 serves to enlarge the angle at which light is incident thereto with respect to the incidence part 13 of the optical lens 10, the micro lens array 14 may be formed to have a shape capable of maximizing this function.

The refraction of light refers to a change in the direction of light at an interface at which mediums having different refractive indexes meet each other, and the emitted light may be guided in a desirable direction by adjusting the refractive index of each medium and an angle formed by the direction of light with respect to the interface.

In the exemplary embodiment of the present invention, a plurality of micro lenses forming the micro lens array 14, may each have a hemispherical shape protruding to the outside from the incidence part 13. By doing so, a considerable amount of the light incident to the micro lens array 14 may be emitted at a large angle. However, the present invention is not limited to the exemplary embodiment, and the shape of the micro lens array may be variable, for example, hemisphere hemispherical, a conic, a triangular pyramidic, a quadrangular pyramidic, a randomly scattered shape, or a mixture thereof, according to embodiments of the present invention.

As set forth above, the micron lens array 14 may serve to refract the incident light at a large angle; however, not all light incident to the incidence part 13 of the optical lens 10 may be refracted as above. In other words, the light incident to the incidence part 13 from the light source 20 may be incident through an area of the incidence part 13 on which the micro lens array 14 is not formed, reflected from the surfaces of the micro lenses, or may be advanced straight as it is, while being refracted only slightly, according to an incident position or an incident angle, even in the case in which light from the light source 20 may be incident to the incidence part 13 through the micro lens array 14.

As described above, a fractional part of the light incident and refracted by the incidence part 13 may be advanced directly to the side surface part 12 and ultimately be emitted, and the majority of the light incident and refracted by the incidence part 13 may be advanced to the reflection part 11. As shown in FIG. 2, since the reflection part 11 may form a planar interface with air, it may generate a total reflection with respect to light having an incident angle exceeding a predetermined critical angle. As described above, a fractional part of the light incident and refracted by the incidence part 13 may be advanced directly to the side surface part 12 and ultimately be emitted, and the majority of the light incident and refracted by the incidence part 13 may be advanced to the reflection part 11. As shown in FIG. 2, since the reflection part 11 may form a planar interface with air, it may generate a total reflection with respect to light having an incident angle exceeding a predetermined critical angle. As described above, as the light which is not sufficiently refracted by the incidence part 13 and substantially advanced to reach the reflection part 11 does not have an incident angle greater than the critical angle, the light reaching the reflection part 11 may be refracted and pass through the interface with air to finally be emitted. In this process, the light may be dispersed or distributed and emitted at different angles; however, only with this, it is difficult to obtain noticeable effects for improving the orientation angle of the light emitting diode. However, light having an incident angle greater than the critical angle may be totally reflected so as not to be emitted to the outside of the optical lens 10, thereby advancing in a direction of the side surface part 12, or again advancing to the incidence part 13.

In this manner, light may be guided in the direction of the side surface part 12 by enlarging an angle at which the light is incident on the reflection part 11, and the micro lens array 14 may serve to enlarge the incident angle at the reflection part 11.

The light guided to the side surface part 12 may no longer be totally reflected, and may need to be emitted to the outside of the optical lens 10. In the case in which the light guided to the side surface part 12 is reflected or totally reflected, there may be an unintentional loss of light which may not be emitted to the outside. Thus, in order to prevent the occurrence of such a case, it is necessary to reduce the incident angle of the light incident to the side surface part 12. Accordingly, the side surface part 12 may be outwardly protruded such that the light totally reflected from the reflection part 11 may be incident thereon in such a manner as to be approximately perpendicular thereto.

On the other hand, the light readvanced to the incidence part 13 may be directly emitted to the outside through the incidence part 13, or may be totally rereflected in the case of a wide incident angle. Even in the case of repeating the total reflection, since the light may be inevitably advanced to the side surface part 12, the light may consequently be emitted by the side surface part, whereby the loss of light may not be caused.

In the optical lens 10 as aforementioned, from the light incident by the incidence part 13 including the optical lens array 14, a certain amount of light L1 may pass directly through the reflection part 11 to be emitted upwardly of the optical lens 10, a certain amount of light L2 may be totally reflected from the reflection part 11 and pass through the side surface part 12 to finally be emitted sidewardly, a certain amount of light L3 may repeat the total reflection and pass through the side surface part 12 or the incidence part 13 to be emitted. In this manner, even in the case of the light emitting diode having an orientation angle remaining within the range of approximately 120°, when the lens does not exist, light may be irradiated sidewardly and backwardly by disposing the optical lens 10 above the light source according to the exemplary embodiment of the present invention.

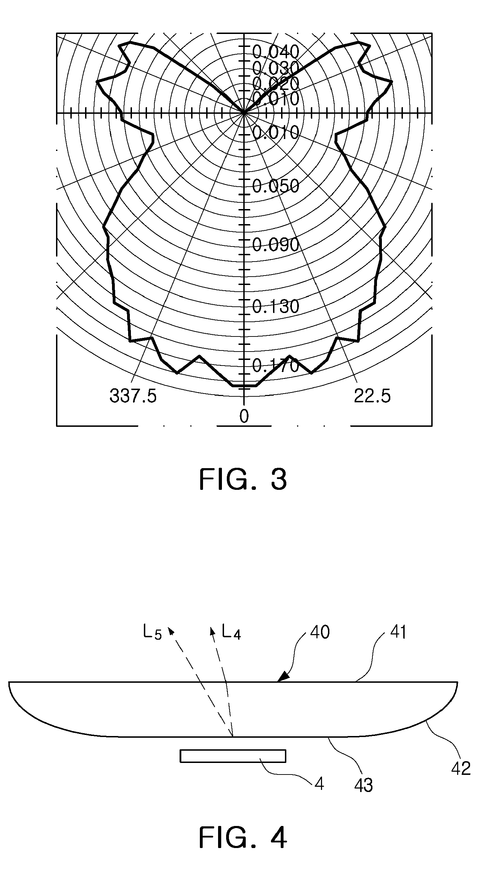

FIG. 3 shows a simulated light distribution curve of the lighting apparatus of FIG. 2. Referring to FIG. 3, it can be confirmed that light emitted from the light source has improved light distribution characteristics through the optical lens 10 according to the exemplary embodiment of the present invention.

FIG. 4 shows a cross sectional view of a lighting apparatus having a light source 4 disposed below the optical lens of FIG. 1 from which the micro lens array 14 is removed, taken along line A-B, together with light paths therefrom.

Referring to FIG. 4, an optical lens 40 having a shape the same as that of the optical lens 10 shown in FIG. 1 and 2, except for the formation of the micro lens array 14 on an incidence part 43 may be illustrated. That is, FIG. 4 is a cross sectional view of the optical lens 40 including the incidence part 43, a side surface part 42, and a reflection part 41 above the light source 4, which also shows light paths L4 and L5 of light incident from the light source 4. Here, in a case in which the micro lens array does not exist, the majority of light of light paths L4 and L5, incident to the incidence part 43, may be not refracted to have large emitting angles, such that it may ultimately be emitted having not been totally reflected.

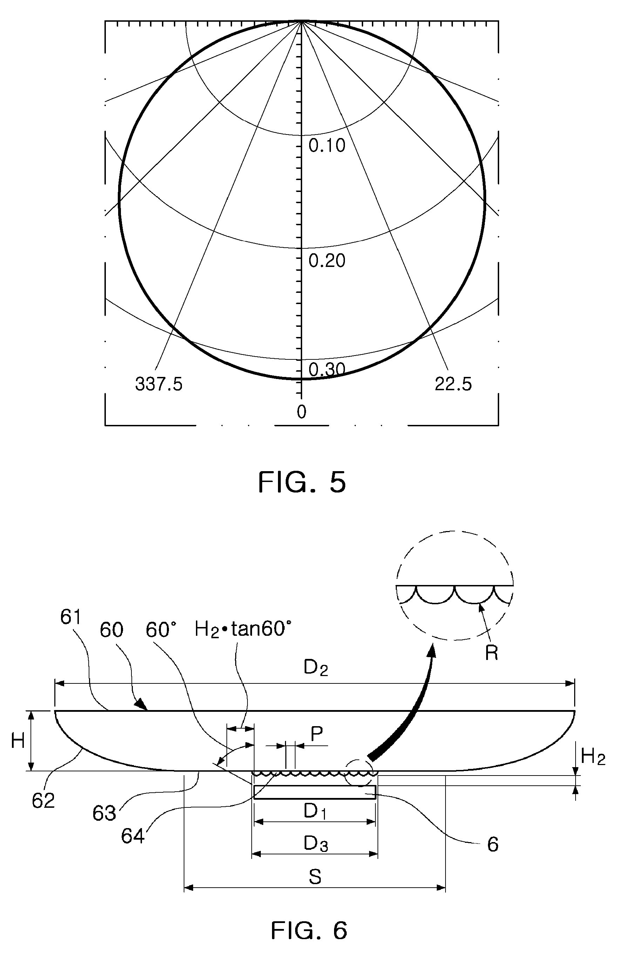

FIG. 5 shows a simulated light distribution curve of the lighting apparatus of FIG. 4. Referring to FIG. 5, even in the case of disposing the optical lens 40 according to the exemplary embodiment of the present invention, when the micro lens array 14 is removed therefrom, the light distribution characteristics thereof may be rarely improved, as compared to the case shown in FIG. 3

As described above, the optical lens 10 may lead to natural light scattering by allowing a certain amount of light to advance, and a certain amount of light to be refracted. In this process, the amount of light and the refractive degree to which the amount of light is refracted may be determined by a combination of diverse variables such as the shape and the formation range of the micro lens array 14, the type of optical lens structure, the interval between micro lens array 14, the diameters and heights of the micro lens array 14, the width of the light source, and the like. Exemplary embodiments with reference to the diverse variables will be now explained in detail.

FIG. 6 is a schematic cross sectional view of an optical lens according to an exemplary embodiment of the present invention, which illustrates reference numerals for explaining length relationships between individual parts configuring the optical lens.

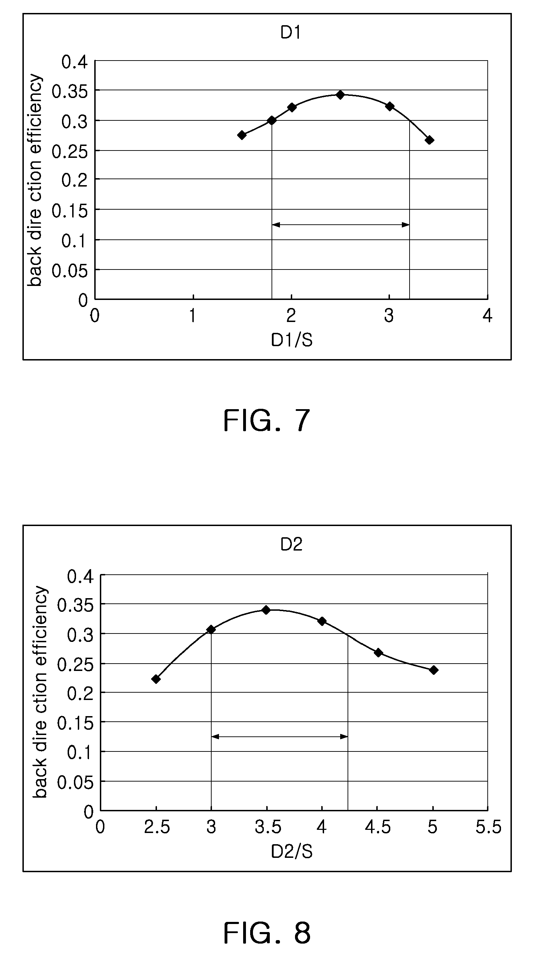

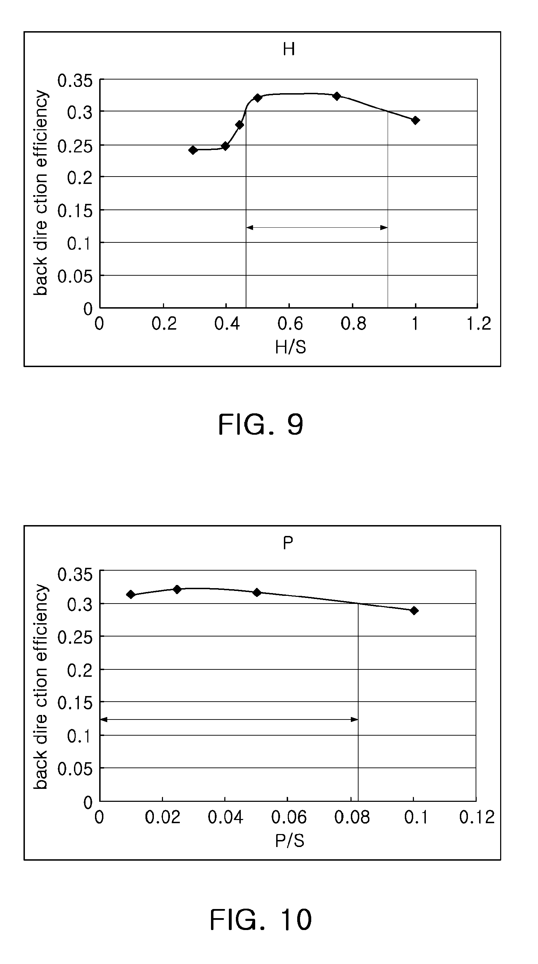

FIGS. 7 through 11 show graphs respectively illustrating a simulated back direction efficiency of light when the lengths of the individual parts of FIG. 6 are varied.

Referring to FIG. 6, a width S of a light source 6, a width D1 of an incidence part 63 of an optical lens 60, a distance H between the incidence part 63 and a reflection part 61 (that is, a height of the optical lens 60), an interval P between micro lenses of a micro lens array 64, and a radius R of each micro lens having a hemispherical shape are defined. 62 denotes a side surface part.

In addition, referring to FIGS. 7 through 11, when D1/S is equal to approximately 2.5, the maximum back direction efficiency of light may be obtained, and preferably, when D1/S is within the range of 1.8 to 3.2, advantageous light efficiency may be obtained. When D2/S is equal to approximately 3.5, the maximum back direction efficiency of light may be obtained, and preferably, when D2/S is within the range of 3 to 4.2, advantageous light efficiency may be obtained. When H/S is equal to approximately 0.5, the maximum back direction efficiency of light may be obtained and preferably, when H/S is within the range of 0.46 to 0.9, advantageous light efficiency may be obtained. When P/S is equal to approximately 0.03, the maximum back direction efficiency of light may be obtained and preferably, when P/S is within the range of 0.08 or less, advantageous light efficiency may be obtained. When R/P is equal to approximately 0.5, the maximum back direction efficiency of light may be obtained and preferably, when R/P is within the range of 0.48 to 0.62, advantageous light efficiency may be obtained.

Referring to Fig. 6, a preferable range of the distance H can be explained. The distance H2 between the light source 6 and the incidence part 63 preferably satisfies the following condition:

$$0 < H2 < (D3-S)/2 \tan A$$

where D3 is a width of a micro lens array 64 and A is a main light direction angle of the light source 6, which defines an area of the incident part 63 to which light generated from the light source is mainly directed. Preferably, A is within a range of 50° to 70°. More preferably, A is about 60°. That is, when A is 60°, the maximum of H2 is smaller than $(D3 - S)/2\sqrt{3}$.

Meanwhile, the optical lenses 10, 40, and 60 may be made of various light-transmitting materials, and preferably, may be made of at least one of polycarbonate and acryl.

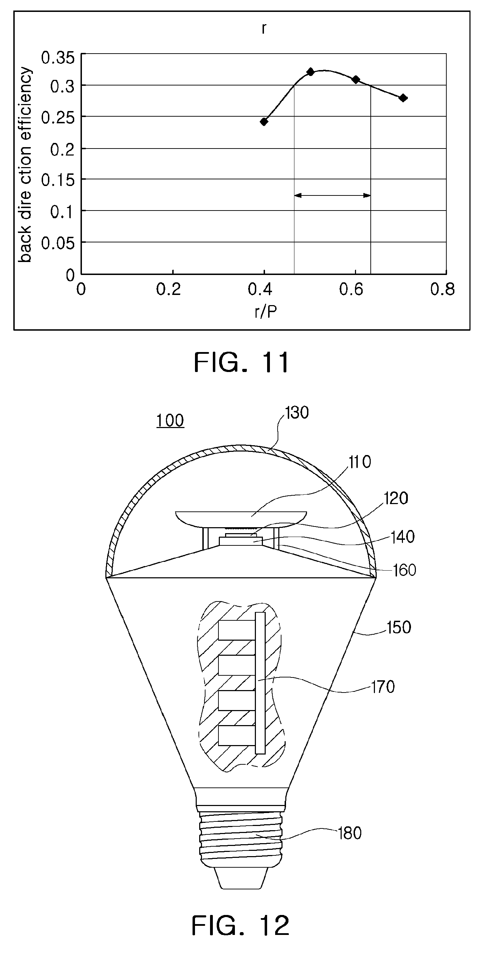

FIG. 12 is schematic cross sectional view of a lighting apparatus 100 using the optical lens according to the exemplary embodiment of the present invention. In the lighting apparatus 100 according to the exemplary embodiment of the present invention, a circuit board 140 may be disposed on a heat dissipating structure 150 and a light source 120 is mounted on the circuit board 140. In this case, the light source 120 may include a plurality of light emitting diodes. An optical lens 110 according the aforementioned embodiments of the present invention is disposed above the light source 120, and the center of the light source 120 may be positioned in such a manner as to correspond to the center of the optical lens 110. In this case, when the width of the optical lens 110 is greater than that of the light source 120, a fixing part 160 may be disposed between the heat dissipating structure 150 and the optical lens 110 so as to firmly fix the optical lens 110. In addition, a cover part 130 may be disposed above the heat dissipating structure 150 in such a manner as to surround the light source 110 and the optical lens 110.

A driving circuit part 170 for operating the light source 110 may be disposed within the heat dissipating structure 150, and an electrical connection part 180 may be formed to be connected with the driving circuit part 170. The lighting apparatus according to the exemplary embodiment of the present invention has a shape similar to that of an incandescent lamp according to the related art, and is merely exemplarily illustrated. Thus, the lighting apparatus according to the exemplary embodiment of the present invention may be variously modified according to the requirements of design.

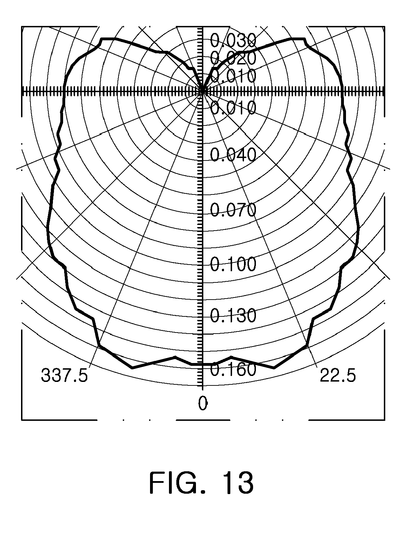

FIG. 13 is a simulated light distribution curve of the lighting apparatus according to the exemplary embodiment of the present invention. Referring to FIG. 13, it can be seen that the light distribution characteristics of the lighting apparatus 110 are improved by using the optical lens 110 according to the exemplary embodiment of the present invention.

As set forth above, according to exemplary embodiments of the invention, by disposing an optical lens performing a light diffusion function, the light of a light emitting diode can be widely spread to be evenly diffused, and at the same time, superior luminous efficiency can be obtained.

While the present invention has been shown and described in connection with the exemplary embodiments, it will be apparent to those skilled in the art that modifications and variations can be made without departing from the spirit and scope of the invention as defined by the appended claims.

**Claims**

1.    An optical lens, comprising:

an incidence part (13) provided as a light incident area and including a micro lens array (14) formed on at least a partial region of a surface thereof;

a reflection part (11) spaced apart from the incidence part (13) by a predetermined distance (H) and configured to reflect at least a certain amount of light having passed through the incidence part (13); and

a side surface part (12) connecting the incidence part (13) and the reflection part (11) and configured to transmit the certain amount of light reflected by the reflection part (11).

2. The optical lens of claim 1, wherein the micro lens array (14) is configured to refract at least a certain amount of light incident on the incidence part (13) at an angle at which the light is totally reflected by the reflection part (11).

3. The optical lens of claim 1 or 2, wherein the incidence part (13) and the reflection part (11) are planes parallel with each other.

4. The optical lens of any one of the claims 1 to 3, wherein the reflection part (11) has a width ($D_2$) greater than a width ($D_1$) of the incidence part (13).

5. The optical lens of any one of the claims 1 to 4, wherein the incidence part (13) and the reflection part (11) have round shapes.

6. The optical lens of any one of the claims 1 to 5, wherein the side surface part (12) has a curved surface shape projecting outwardly.

7. The optical lens of any one of the claims 1 to 6, wherein the micro lens array (14) is formed of micro lenses, each having a hemispherical shape projecting from a lower surface of the incidence part (13).

8. The optical lens of any one of the claims 1 to 7, wherein the micro lens array (14) includes at least one micro lens having a hemispherical, conic, triangular pyramidal, quadrangular pyramidal or randomly scattered shape.

9. The optical lens of any one of the claims 1 to 8, wherein the optical lens (10) is made of at least one of polycarbonate and acryl.

10. A lighting appratus, comprising:

a light source (120); and
at least oneoptical lens (110) of any one of the claims 1 to 9.

11. The lighting appratus of claim 10, wherein a ratio of a distance between (H) the reflection part (11) and the incidence part (13) to the width (S) of the light source (120) is within a range between 0.46 and 0.9.

12. The lighting appratus of claim 10 or 11, wherein the micro lens array (14) has a plurality of micro lenses, each having a hemispherical shape projecting from a lower surface of the incidence part (13).

13. The lighting appratus of any one of the claims 10 to 12, wherein a formation area of the micro lens array (14) is greater than an area corresponding to the light source (120).

14. The lighting appratus of any one of the claims 10 to 13, further comprising a heat dissipating structure (150) disposed on a lower surface of the light source (120).

15. The lighting appratus of claim 14, further comprising a fixing part (160) between the optical lens (110) and the heat dissipating structure (150).

FIG. 1

A–B

FIG. 2

**FIG. 3**

**FIG. 4**

FIG. 5

FIG. 6

FIG. 7

FIG. 8

FIG. 9

FIG. 10

FIG. 11

FIG. 12

FIG. 13

Europäisches
Patentamt

European
Patent Office

Office européen
des brevets

## EUROPEAN SEARCH REPORT

Application Number

EP 11 17 6977

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2006/119250 A1 (SUEHIRO YOSHINOBU [JP] ET AL) 8 June 2006 (2006-06-08) * paragraph [0448] - paragraph [0451]; figure 74 * | 1-15 | INV. G02B17/08 G02B3/00 F21V13/04 H01L33/58 F21K99/00 B29D11/00 F21V5/04 F21V7/00 |
| Y | CN 201 237 152 Y (JIHONG LI [CN]) 13 May 2009 (2009-05-13) * abstract; figure 1 * | 1-15 | |
| A | US 2008/192479 A1 (WANNINGER MARIO [DE]) 14 August 2008 (2008-08-14) * abstract; figure 1 * | 1 | |
| A | US 2009/310368 A1 (INCERTI EDDA [IT] ET AL) 17 December 2009 (2009-12-17) * abstract; figure 4 * | 1 | |

TECHNICAL FIELDS
SEARCHED (IPC)

G02B
F21V
H01L
F21K
B29D

The present search report has been drawn up for all claims

| Place of search | Date of completion of the search | Examiner |
|---|---|---|
| The Hague | 1 November 2011 | Lehtiniemi, Henry |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 11 17 6977

This annex lists the patent family members relating to the patent documents cited in the above-mentioned European search report.
The members are as contained in the European Patent Office EDP file on
The European Patent Office is in no way liable for these particulars which are merely given for the purpose of information.

01-11-2011

| Patent document cited in search report | | Publication date | Patent family member(s) | | Publication date |
|---|---|---|---|---|---|
| US 2006119250 | A1 | 08-06-2006 | AU | 2002365761 A1 | 17-06-2003 |
| | | | CN | 1586017 A | 23-02-2005 |
| | | | EP | 1453107 A1 | 01-09-2004 |
| | | | WO | 03049207 A1 | 12-06-2003 |
| CN 201237152 | Y | 13-05-2009 | NONE | | |
| US 2008192479 | A1 | 14-08-2008 | WO | 2006026939 A1 | 16-03-2006 |
| | | | DE | 102004043516 A1 | 23-03-2006 |
| | | | EP | 1787155 A1 | 23-05-2007 |
| | | | JP | 4778514 B2 | 21-09-2011 |
| | | | JP | 2008512706 A | 24-04-2008 |
| | | | KR | 20070053721 A | 25-05-2007 |
| US 2009310368 | A1 | 17-12-2009 | CA | 2650677 A1 | 08-11-2007 |
| | | | CN | 101479522 A | 08-07-2009 |
| | | | EP | 2016330 A1 | 21-01-2009 |
| | | | WO | 2007125564 A1 | 08-11-2007 |

EPO FORM P0459

For more details about this annex : see Official Journal of the European Patent Office, No. 12/82

**EP 2 418 531 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020100076301